(19) Europäisches Patentamt
European Patent Office
Office européen des brevets

(11) **EP 2 725 595 A1**

(12) **EUROPEAN PATENT APPLICATION**

(43) Date of publication:
**30.04.2014 Bulletin 2014/18**

(51) Int Cl.:
*H01G 5/16* (2006.01)     *H01G 5/18* (2006.01)

(21) Application number: **12306326.5**

(22) Date of filing: **25.10.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Delfmems**
**59650 Villeneuve d'Ascq (FR)**

(72) Inventor: **Pavageau, Christophe**
**59650 Villeneuve d'Ascq (FR)**

(74) Representative: **Matkowska, Franck**
**Matkowska & Associés**
**9, rue Jacques Prévert**
**59650 Villeneuve d'Ascq (FR)**

(54) **MEMS fixed capacitor comprising a gas-containing gap and process for manufacturing said capacitor**

(57) The MEMS fixed capacitor (1) comprises a bottom metal electrode (3) formed onto a substrate (S), a top metal electrode (2) supported by metal pillars (5) above the bottom metal electrode, and a gas-containing gap (4) forming a non-solid dielectric layer between said top (2) and bottom (3) metal electrodes ; the distance (D) between the top (2) and bottom (3) metal electrodes is not more than 1μm and the thickness (E) of the top metal electrode (2) is not less than 1μm.

FIG.2

## Description

## Technical field

The present invention relates to a novel MEMS fixed capacitor with a gas-containing gap forming a dielectric layer, to an Integrated Circuit (IC) comprising at least one electric interconnection line embedding such a novel MEMS fixed capacitor, and to a process for manufacturing said MEMS fixed capacitor.

## Prior art

Capacitors are well known in the art and are implemented by inserting a dielectric insulator material between two metal electrodes. The quality of the dielectric material has a very strong impact on the quality factor (Q) of the capacitor. It is usual to find discrete capacitor products suitable for microwave operations with high quality factors as high as 100 or more. Such high values require however the use of very high quality dielectric films, which requires special and well controlled manufacturing process.

Micro-Elecro-Mechanical Systems (MEMS) capacitors are also well known and described for example in PCT application WO 2006/063257 and in US patent n° 6,437,965.

In particular, a MEMS capacitor having a fixed capacitance value, and referred therein as "*MEMS fixed capacitor*" is disclosed in PCT application WO 2006/063257. Said MEMS fixed capacitor (see notably figure 8A) comprises three metallic electrodes: a top electrode (capacitive plate CP1), a bottom electrode (capacitive plate CP2), and an intermediate electrode (capacitive CP3) interposed between said top and bottom electrodes. The top electrode CP1 is electrically connected to the bottom electrode CP2. The bottom electrode CP2 is formed onto a dielectric layer (DE), which has been deposited onto a substrate (S). The intermediate electrode CP3 is formed above the bottom electrode CP2 with an air gap of small thickness (typically about $0.5\mu m$) between the intermediate CP3 and bottom electrodes CP2. Said air gap forms a dielectric insulator layer and is obtained by etching a sacrificial layer that has been previously formed between the two electrodes CP2, CP3. The top electrode CP1 is formed onto a thick beam oxide layer BOL that is interposed between the top electrode CP1 and the intermediate electrode CP3. This thick beam oxide layer BOL has typically a thickness about $2\mu m$, and gives to these electrodes CP1, CP3 the required mechanical strength. In this variant of PCT application WO 2006/063257, the thick beam oxide layer BOL is a structural layer that is necessary for maintaining the gap between the two capacitive plates CP2 and CP3. This thick beam oxide layer BOL however complicates the manufacturing process. Furthermore this thick beam oxide layer BOL can involve dielectric losses that reduce the quality factor of the capacitor, jeopardize the benefit of the air capacitor formed between the bottom electrode CP2 and the intermediate electrode CP3, and detrimentally limit the use of said MEMS fixed capacitor at high frequencies.

MEMS capacitor having a variable capacitance value are also known and disclosed for example in American patent US 6,437,965. The capacitor disclosed in US 6,437,965 comprises a bottom capacitive electrode on a substrate and a movable bridge forming a top capacitive electrode suspended above the bottom capacitive electrode. Said bridge is deformable and movable between a lower position and an upper position under electric actuation forces, in order to provide high and low selectable capacitive values. Such a MEMS capacitor having a variable capacitance value involves a thick air gap between the bottom and top capacitive electrodes at rest, and an upper capacitive electrode of small thickness in order to be easily bendable under electric actuation forces. MEMS capacitors having a variable capacitance value have inherently the following drawbacks:

- dielectric stiction,
- dielectric charging modifying the mechanical behavior of the MEMS,
- mechanical fatigue,
- self-actuation (or self-biasing) and self-maintaining (or latching),
- low $C_{on}/C_{off}$ ratio (typically between 3 to 10),
- low accuracy on the $C_{on}$ value due to the surface roughness,
- large contact area.

## Objective of the invention

An objective of the invention is to propose novel MEMS fixed capacitor, i.e. a MEMS capacitor having a fixed capacitance value, which can have a high capacitance density and a high quality factor.

Another objective of the invention is to propose a novel MEMS fixed capacitor that can be manufactured with a MEMS process making use of sacrificial layer(s).

## Summary of the invention

This objective is achieved by the MEMS fixed capacitor of claim 1, which comprises a bottom metal electrode formed onto a substrate, a top metal electrode supported by metal pillars above the bottom metal electrode, and a gas-containing gap forming a non-solid dielectric layer between said top and bottom metal electrodes, wherein the distance (D) between the top and bottom metal electrodes (i.e. the thickness of the gas-containing gap) is not more than $1\mu m$ and the thickness (E) of the top metal electrode is not less than $1\mu m$.

When a strong potential difference exists between the top and bottom electrodes, there is a risk that the top electrode can bend under the large electrostatic force attraction, thereby detrimentally modifying the capacitance value of the MEMS capacitor. This phenomenon increases obviously when the surface of the electrodes is enlarged, and also when the distance between the top and bottom electrodes is decreased.

The applicant has demonstrated that an increase of the distance between the top and bottom electrodes is detrimentally decreasing the capacitance density, but that a smaller distance between the top and bottom electrodes also detrimentally increases the deformability of the top electrode. In return, the applicant has demonstrated that the thickness of the top electrode does not substantially affect the capacitance density of the capacitor, and that a thicker top electrode is better for reducing the deformability of the top electrode. Within the scope of the invention, the use of a thicker top metal electrode (not less than $1\mu$m) combined with a smaller distance between the top and bottom metal electrodes (i.e. not more than $1\mu$m) enables to achieve a MEMS fixed capacitor which can advantageously have a high capacitance density, and whose top metal electrode is advantageously less easily deformable under electrostatic force attraction.

Furthermore the use in the invention of a gas-containing gap between the top and bottom electrodes, instead of a solid dielectric layer, and the use of a thicker top metal electrode, enable to achieve more easily, and at lower manufacturing costs, a capacitor having a high quality factor within a broad frequency range, and typically for low-frequency applications to multi-gigahertz frequency applications.

The deformability of the top electrode of the MEMS fixed capacitor of the invention can be defined by the following deformability parameter DEF:

$$DEF = \Delta C/(V^2.C_0), \text{ wherein:}$$

- V is the value of a voltage applied between the top and bottom metal electrodes;
- $C_0$ is the capacitance value of the MEMS fixed capacitor with no voltage applied between the top and bottom metal electrodes;
- $\Delta C$ is the variation of the capacitance value when a voltage V is applied between the top and bottom metal electrodes; $\Delta C = C_1 - C_0$, C1, being the capacitance value of the MEMS fixed capacitor when a voltage V is applied between the top and bottom metal electrodes.

In a preferred embodiment of the invention, the MEMS fixed capacitor is characterized by a deformability parameter DEF that is not more than $10^{-4}$ (i.e. $\Delta C/(V^2.C_0)$ $\leq 10^{-4}$ ) for a voltage V ranging at least up to 45V, and more preferably at least up to 100V.

The invention also relates to an Integrated Circuit (IC) comprising at least one electric interconnection line embedding at least one MEMS fixed capacitor as defined above.

The invention further relates to a novel process for manufacturing a MEMS fixed capacitor, comprising the following steps:

(a) depositing a bottom metal layer onto a substrate;
(b) patterning the bottom metal layer in such a way to create at least one bottom metal electrode in the bottom layer;
(c) depositing a sacrificial layer onto the bottom layer and the substrate;
(d) patterning the sacrificial layer in such a way to create wells through the whole thickness of the sacrificial layer;
(e) filling the wells in the sacrificial layer with a metal in order to form supporting pillars;
(f) depositing at least one top metal layer onto the sacrificial layer;
(g) patterning the top metal layer(s) in order to form at least one top metal electrode;
(h) etching the sacrificial layer in order to remove the whole sacrificial layer and create the air gap between the top metal electrode and the bottom metal electrode.

In a first variant, aforesaid steps (e) and (f) are performed separately and successively. In another variant, aforesaid steps (e) and (f) are performed simultaneously by depositing the at least one top metal layer onto the sacrificial layer, in such a way to also fill the wells previously formed in the sacrificial layer.

A final drying step (i) which is already known per se, can be also performed after the etching step (h), by blowing a drying gas, such as for example supercritical $CO_2$, or by practicing a marangoni effect, or by alcohol sublimation.

**Brief description of the drawings**

The characteristics and advantages of the invention will appear more clearly on reading the following detailed description which is made by way of non-exhaustive and non limiting examples, and with reference to the accompanying drawing on which:

- Figure 1 is a top view of a MEMS fixed capacitor of the invention (1st variant);
- Figure 2 is a view in vertical cross section of the MEMS fixed capacitor of figure 1 in plane II-II;
- Figure 3 is a view in vertical cross section of the MEMS fixed capacitor of figure 1 in plane III-III;
- Figures 4 to 11 are views in vertical cross section showing the main different successive steps for manufacturing a MEMS fixed capacitor;
- Figure 12 is a top view of a 2nd variant of a MEMS fixed capacitor of the invention;
- Figure 13 is a view in vertical cross section of the MEMS fixed capacitor of figure 12 in plane XIII-XIII;
- Figure 14 is a view in vertical cross section of the MEMS fixed capacitor of figure 1 in plane XIV-XIV;

- Figure 15 is a view in vertical cross section of third variant of a MEMS fixed capacitor of the invention;
- Figure 16 is a view in vertical cross section of fourth variant of a MEMS fixed capacitor of the invention;
- Figure 17 is a view in vertical cross section of fifth variant of a MEMS fixed capacitor of the invention;
- Figure 18 is graph showing the capacitance density of a MEMS fixed capacitor as a function of the top electrode thickness;
- Figure 19 is graph showing the capacitance density of a MEMS fixed capacitor as a function of the distance between the top and bottom metal electrodes;
- Figure 20 is graph showing the capacitance density of a MEMS fixed capacitor as a function of the distance between supporting metal pillars;
- Figure 21 is a graph showing the deformability (DEF) of a MEMS fixed capacitor as a function of the top electrode thickness;
- Figure 22 is a graph showing the deformability (DEF) of a MEMS fixed capacitor as a function of the distance between the top and bottom metal electrodes;
- Figure 23 is a graph showing the deformability (DEF) of a MEMS fixed capacitor as a function of the distance between supporting metal pillars;
- Figure 24 is a top view of a digital capacitor bank comprising several MEMS fixed capacitors of the invention;
- Figure 25 is a view in vertical cross section of the digital capacitor bank of figure 24 in plane XXV-XXV;
- Figure 26 is the electrical equivalent schematic of the digital capacitor bank of figure 24.

**Detailed description**

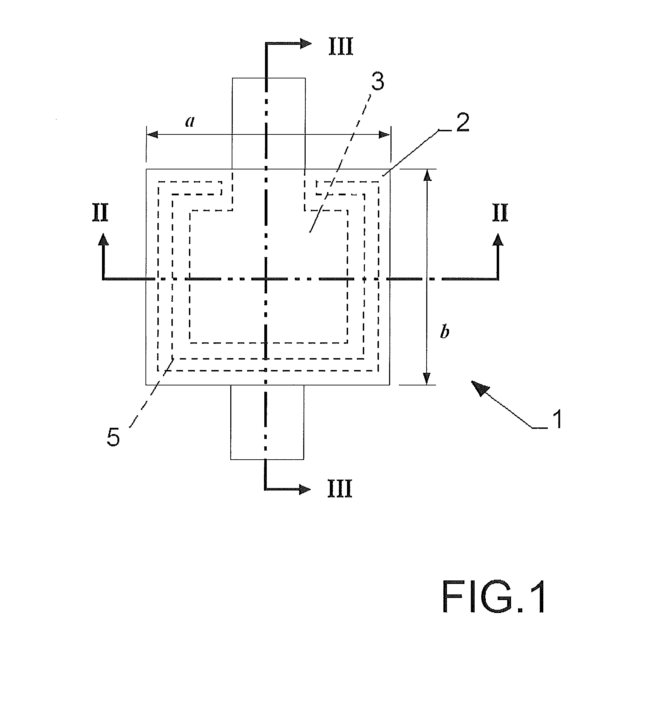

Variant of figures 1 to 3

In reference to the variant of figures 1 to 3, the MEMS fixed capacitor 1 is made of three metal layers L1, L2 and L3 deposited onto a substrate S, namely: a bottom layer L1 deposited directly onto the substrate S, an intermediate metal layer L2 deposited directly onto the bottom metal layer L2, and a top metal layer L3. The substrate S can be for example made of silicon, silicon-on-insulator, silicon-on-sapphire, gallium-arsenide, gallium-nitride, glass, fused-silica, fused-quartz, alumina or any other substrate material used for the manufacturing of semiconductor and microelectronics devices.

The MEMS fixed capacitor 1 comprises a top metal electrode 2 of constant thickness E, formed in the top metal layer L3, and a bottom metal electrode 3 formed in the bottom metal layer L1. The top electrode 2 is supported above the bottom electrode 3 only by metal pillars 5 that are not in contact with the bottom metal electrode 3. In this particular variant, the metal pillars 5 are formed in the intermediate metal layer L2.

An air gap 4 is provided between the top electrode 2 and bottom electrode 3. In this particular variant, the distance D between the top electrode 2 and bottom electrode 3 (i.e. thickness of the air gap 4) is constant over the whole surface of the electrodes.

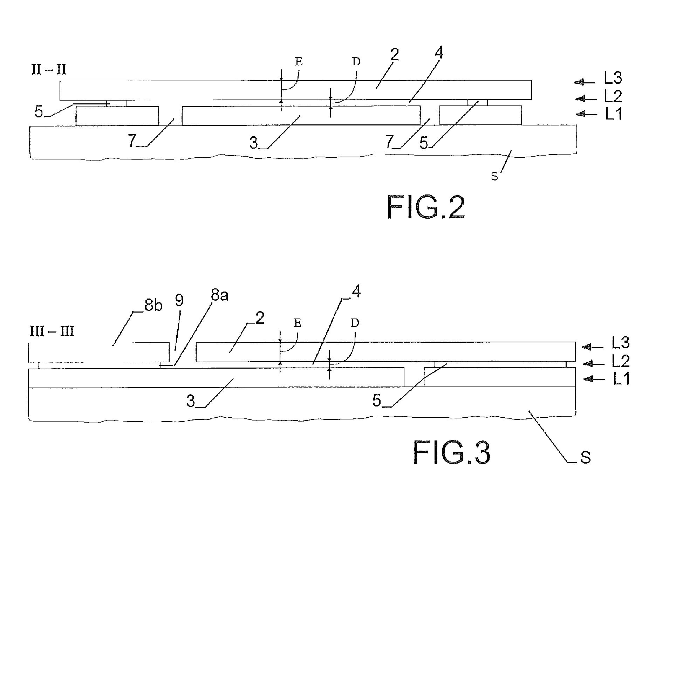

In reference to figures 2 and 3, interruptions 7 are made in the bottom metal layer L1 in order to isolate the bottom electrode 3 from the metal supporting pillars 5.

In reference to figure 3, the bottom electrode 3 is connected to a metallic connection 8 made of two parts 8a and 8b of the intermediate metal layer L2 and top metal layer L3 respectively. An interruption 9 is provided in the top metal layer L3 in order to isolate the top electrode 3 from this metallic connection 8.

The metallic layer L1, L2 and L3 can be made of any metal having high electric conductivity, like for example gold, aluminium, copper, or any electrically conductive alloy.

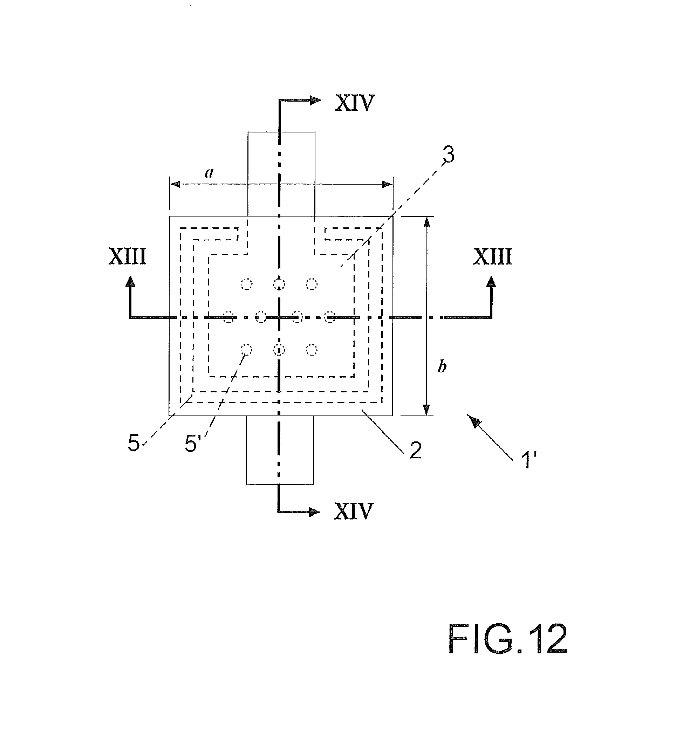

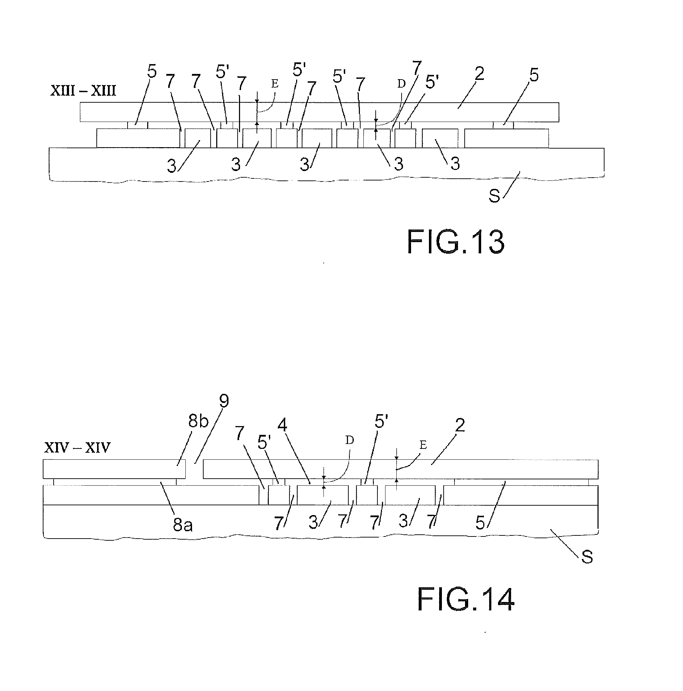

Variant of figure 12 to 14

In the variant of figure 12 to 14, the MEMS fixed capacitor comprises additional cylindrical pillars 5' for supporting the top electrode 2. These additional pillars 5' are useful for top electrodes having a large surface. In the particular variant of figure 12, the transverse cross section of the additional pillars 5' is circular. This transverse cross section of additional pillar 5' can be however of any other different shape, and notably can have any polygonal shape (rectangular, square, ...).In this variant, each pillar 5' forms an equilateral triangle with two next pillars 5'. In another variant, the pillars 5' could be positioned differently.

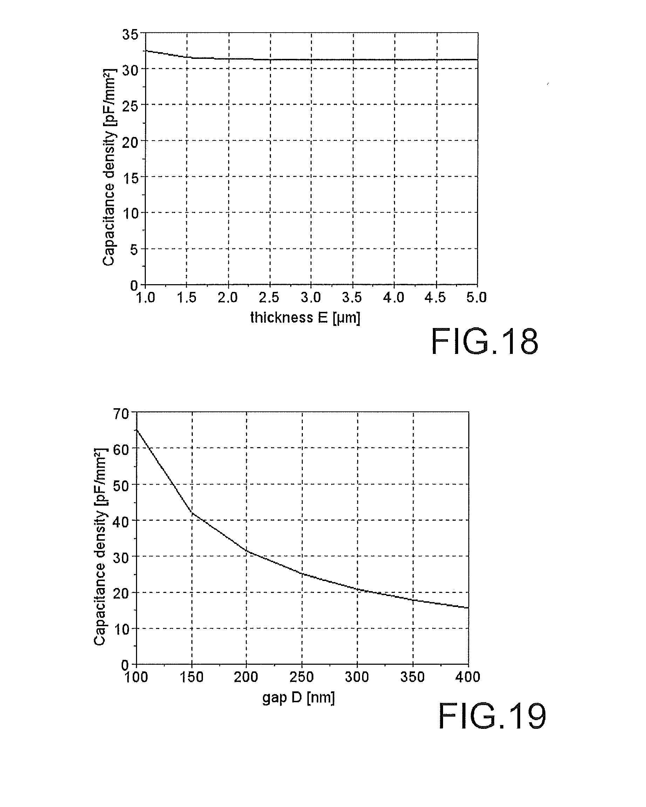

Results of simulation - Figures 18 to 23

Simulations of the capacitance density (Capacitance_Density) and deformability (DEF) have been performed on different structures of MEMS fixed capacitor of the invention made of gold layers L1, L2, L3.

The parameter DEF for characterizing the deformability of the top electrode 2 has already been previously defined. The capacitance density (Capacitance_Density) is given by the following formula :

$$\text{Capacitance\_Density} = C/S_{tot},$$

wherein :

- C is the capacitance of the capacitor;
- $S_{tot}$ is the total surface of the capacitor, including notably the pillars.

For sake of clarity, in reference to figure 1 or to figure 12, the total surface of the capacitor $S_{tot}$ is given by the formula: $S_{tot} = a \times b$.

In particular, the results of the simulations performed on the structure of figures 12 to 14 are shown on figures 18 to 23.

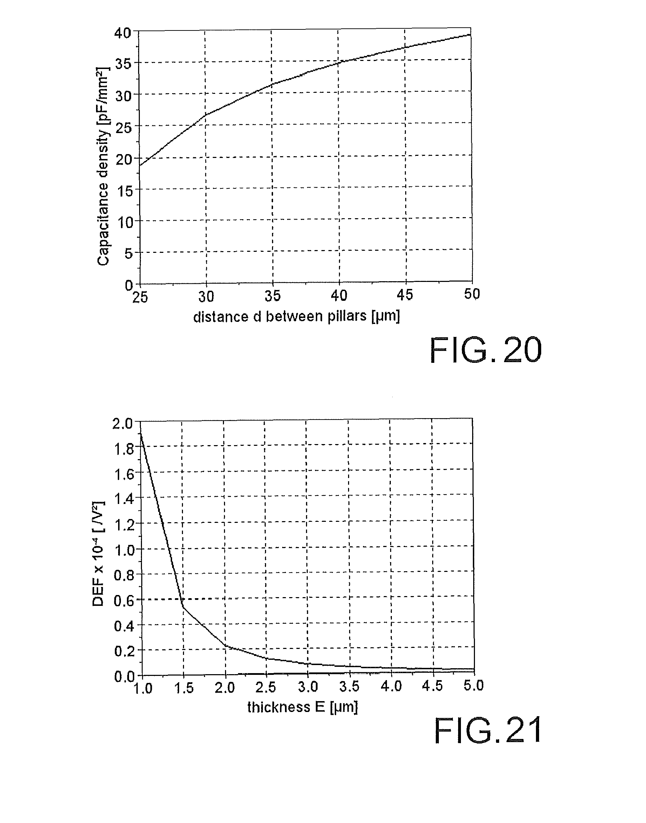

- Figures 18 and 21: the thickness E of the top electrode 2 is varied from $1\mu m$ to $5\mu m$;

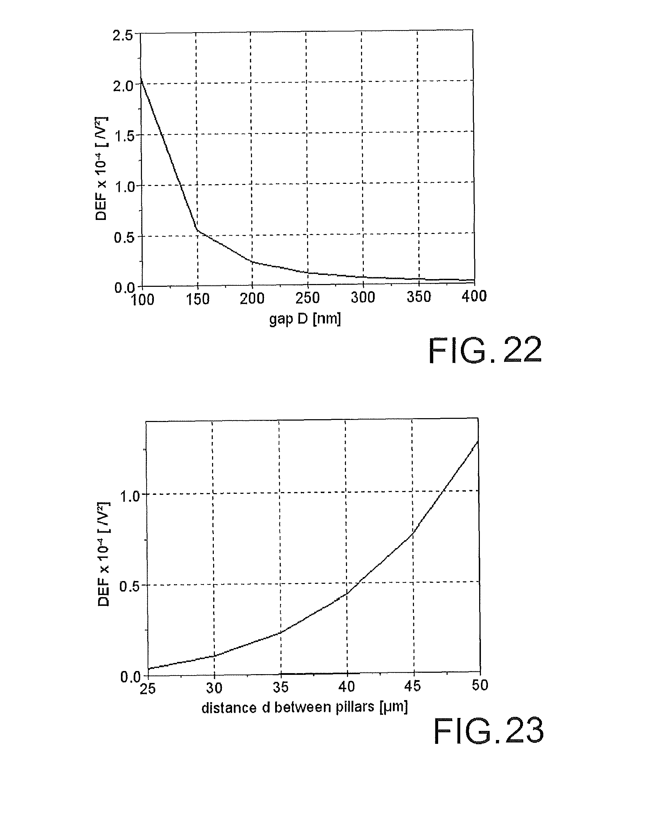

- Figures 19 and 22: the thickness D of the air gap 4 between top electrode 2 and bottom electrode 3 is varied from $0.1\mu m$ to $0.4\mu m$;
- Figures 20 and 23: the distance d between additional pillars 5' is varied from $25\mu m$ to $50\mu m$.

For each set of parameter the capacitance density (figures 18 to 20) and the deformability of the top electrode (figures 21 to 23) are calculated for a voltage V equal to 15V.

For the graphs of figures 18 and 21, the distance D of the air gap 4 was set to 200nm, and the distance d between pillars 5 was set to $35\mu m$; for the graphs of figures 19 and 22, the thickness of the top electrode 2 was set to $2\mu m$ and the distance d between pillars 5 was set to $35\mu m$; for the graphs of figures 20 and 23, the distance D of the air gap 4 was set to 200nm, and the thickness of the top electrode 2 was set to $2\mu m$.

Figures 19 and 22 show that an increase of the distance D between the top and bottom electrodes 2, 3 is detrimentally decreasing the capacitance density, but that a higher distance between the top and bottom electrodes 2, 3 also detrimentally decreases the deformability of the top electrode. In return, figure 18 shows that the thickness E of the top electrode 2 does not really affect the capacitance density of the capacitor, and figure 21 shows that a thicker top electrode 2 is better for reducing the deformability of the top electrode.

Within the scope of the invention, in order to achieve a MEMS fixed capacitor having a top electrode 2 that is advantageously substantially not deformable under electrostatic force attraction, the parameter DEF is preferably not more than $10^{-4}$ for voltage at least up to 45V, and even more preferably for voltage at least up to 100V.

More particularly, in order to achieve a MEMS fixed capacitor of high capacitance density and having a top electrode 2 that is advantageously substantially not deformable under electrostatic force attraction, the thickness E of the top electrode 2 is not less than $1\mu m$, and is preferably not less than $1.5\mu m$, and even more preferably not less than $2\mu m$; the distance D between the top and bottom electrodes 2, 3 is preferably not more than $1\mu m$, even more preferably not more than $0.4\mu m$, and is also preferably not less than $0.15\mu m$.

Figures 20 and 23 show that that an increase of the distance d between the pillars 5' in the variant of figure 12 increases the capacitance density (figure 20) but in return also more strongly increases the deformability of the top electrode 2 (figure 23). Preferably, in the variant of figure 12 with additional pillars 5', the distance d between additional pillars 5 will be set to a value between $25\mu m$ and $50\mu m$.

In the invention, the use of a gas-containing gap 4 between the top and bottom electrodes, instead of a solid dielectric layer, enables to achieve more easily, and at lower manufacturing costs, a capacitor having a high quality factor within a broad frequency range, and typically for low-frequency applications to multi-gigahertz frequency applications. In particular, with the invention it is for example possible to make fixed MEMS capacitor having a quality factor higher than 100, and even more higher than 1000, at very high frequencies, and typically at frequencies higher than 700MHz, and even more preferably at frequencies higher than 2GHz.

Within the scope of the invention, said gas-containing gap 4 can be gap containing a dielectric gas. Although air is preferred as dielectric gas for ease of manufacture, the invention is however not limited to an air gap, and gap 4 can be filled with any other dielectric gas, including for example nitrogen, argon. In a variant, the gap 4 can also contain a gas, and notably air, under partial vacuum.

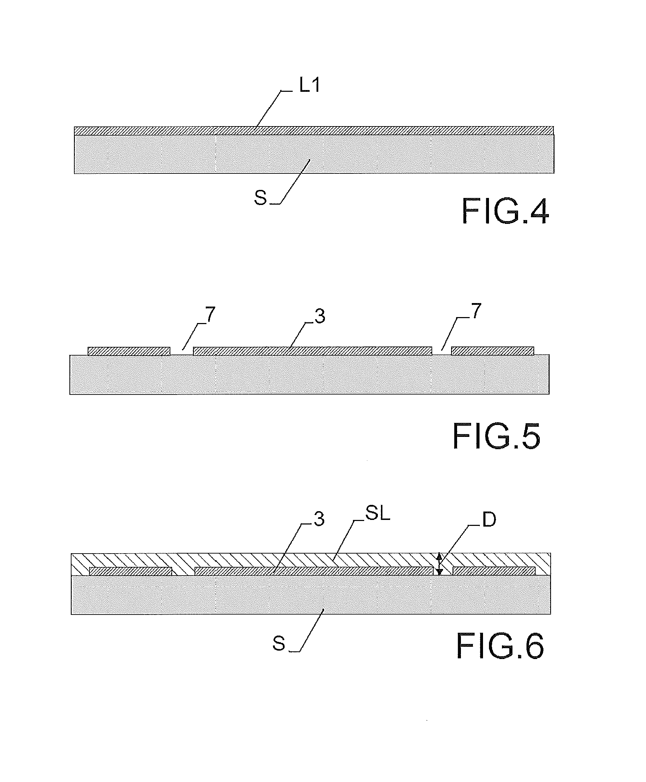

Manufacturing process - Figures 4 to 11

The MEMS fixed capacitor 1 or 1' of the invention can be manufactured easily and at low cost by performing the successive manufacturing steps that are going now to be described in reference to figures 4 to 11.

Step 1/8 - figure 4

A first layer (bottom layer) L1 of metal is deposited on a substrate S. The metal of layer L1 is for example gold and the substrate S is for example made of silicon.

Step 2/8 - Figure 5

The layer L1 is patterned in such a way to create interruptions 7 and at least one bottom electrode 3 in the bottom layer L1.

Step 3/8 - Figure 6

A sacrificial layer SL is deposited onto the bottom layer L1 and substrate S. This sacrificial layer SL can be for a monolayer, or can be a multilayer, and notably a bi-layer made of two superposed layers for example made of chrome ad silicon dioxide ($SiO_2$) respectively. The sacrificial SL layer can also be made of metal such as for example copper, chrome,... The sacrificial SL layer can also be made of any photosensitive resin used in microelectronics, such as for example PMGI (Polydimethylglutarimide), AZ1518,...

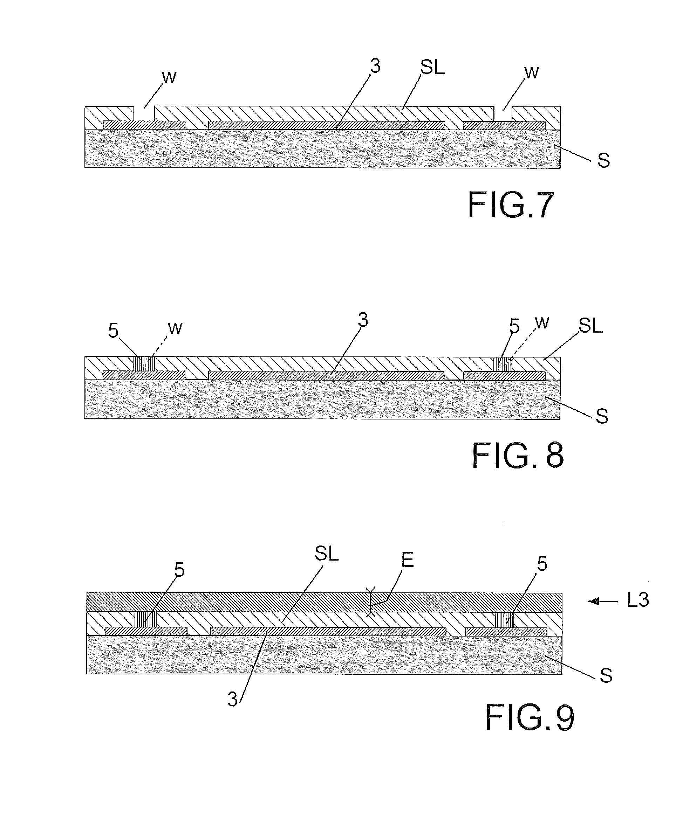

Step 4/8 - Figure 7

The sacrificial layer SL is patterned in such a way to create wells through the whole thickness of the sacrificial layer SL. Said wells will be used afterwards for the building of the pillars 5 (and also for the building of the additional pillars 5' in the variant of figure 12).

Step 5/8 - Figure 8

A second metal deposition step (intermediate layer L2) is performed by electroplating, in order to fill the well W with a metal, like for example gold.

Step 6/8 - Figure 9

A third metal layer (for example a gold layer) is deposited onto the sacrificial layer SL, in order to form the top metal layer L3 covering the top surface of the sacrificial layer SL.

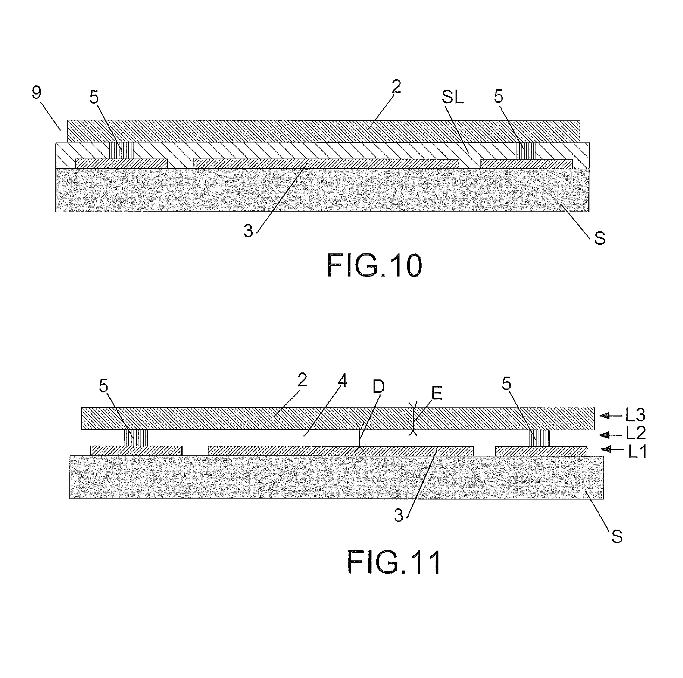

Step 7/8- Figure 10

The top metal layer L3 is patterned in order to form the interruption 9 and the top metal electrode 2

Step 8/8 - Figure 11

A final releasing step is performed by etching the sacrificial layer SL in order to remove the whole sacrificial layer SL and create notably the air gap 4 between the top electrodes 2 and the bottom electrode 3.

A final drying step, which is already well known per se, can be also performed after the etching step 8/8, by blowing a drying gas, such as for example supercritical $CO_2$, or by practicing a marangoni effect, or by alcohol sublimation.

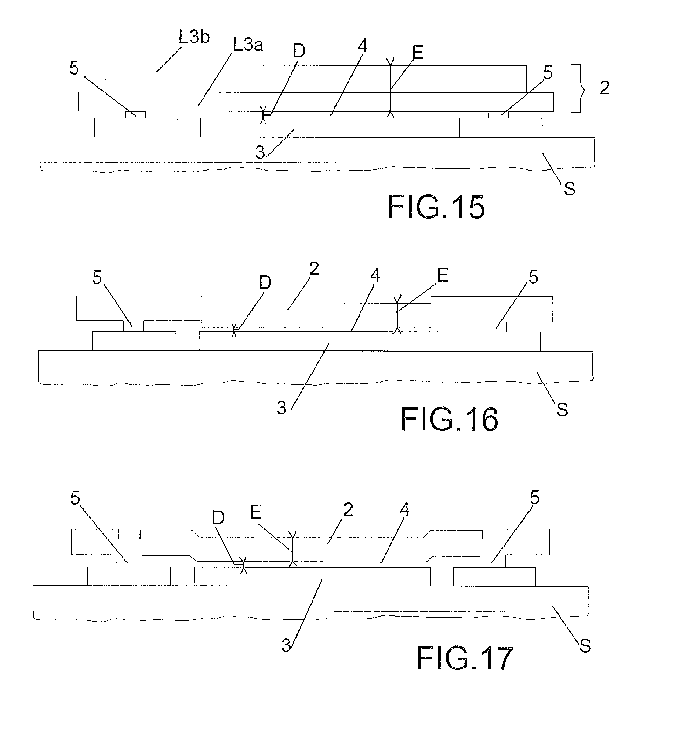

Variant of figure 15

In the variant of figure 15, the top electrode is made of two distinct metal layers L3a and L3b. The top layer L3b may cover all or part of the lower layer L3a, depending on the mechanical characteristics.

Variant of figure 16

In the variant of figure 16, a bushing step has been performed in the top layer L3 in order to reduce the thickness D of the air gap between the top electrode 2 and the bottom electrode 3.

Variant of figure 17

In this variant, only two metal layers L1 and L3 are used and the pillars 5 are processed and formed simultaneously with the top electrode 2 and from the same metal layer L1.

Standard Integrated Circuit (IC) always comprises electric interconnection lines for connecting for example two electric functional circuits or elements, including for example capacitive or ohmic switches, inductances, ohmic resistances. Said interconnection lines can be for example a simple metal strip, a microstrip, a CoPlanar Waveguide (CPW), a stripline. Advantageously MEMS fixed capacitors 1 or 1' of the invention can be easily embedded in the electric interconnection lines of a standard Integrated Circuit (IC) without increasing the IC's area. This smart use of the interconnection lines of an IC for a monolithic integration of MEMS fixed capacitors in the IC can be useful for example for making capacitor banks embedded in a standard IC or for adding capacitive functionalities to an IC.

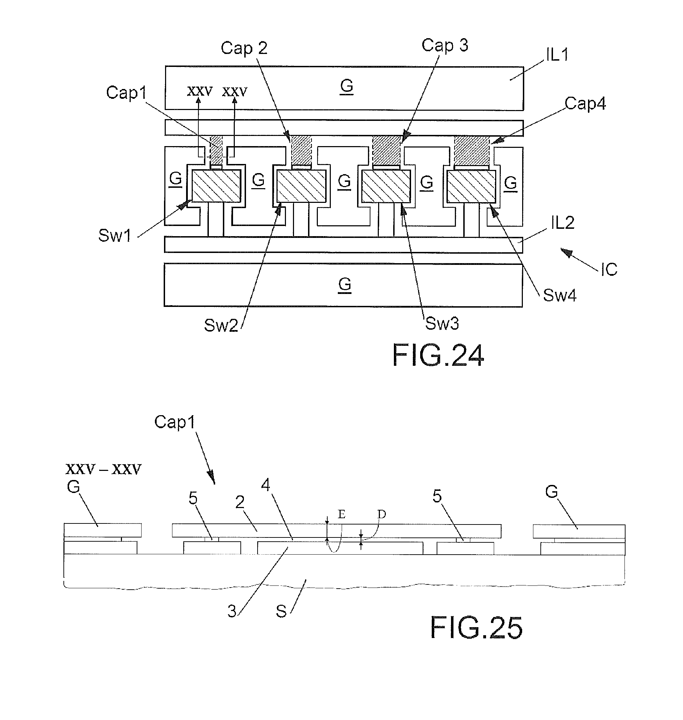

Figures 24 and 25 show an example of an integrated circuit (IC) embedding several MEMS fixed capacitors of the invention in the interconnection lines of the integrated circuit (IC). On figures 24 and 25, references G are identifying the ground of the IC.

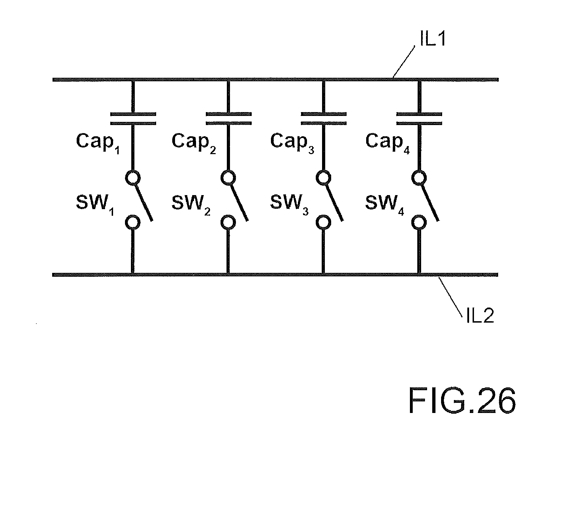

In reference to figure 24, the Integrated Circuit (IC) is in this particular case a digital capacitor bank comprising four MEMS switches (or MEMS relays) SW1, SW2, SW3, SW4 that are connected in parallel (figure 26) by electrical interconnection lines IL1 and IL2 (signal lines). In this example, the interconnection line IL1 is embedding MEMS fixed capacitors Cap1, Cap2, Cap3, Cap4 of the invention for each switch SW1, SW2, SW3, SW4.

## Claims

1. A MEMS fixed capacitor (1 ; 1') comprising a bottom metal electrode (3) formed onto a substrate (S), a top metal electrode (2) supported by metal pillars (5 ; 5') above the bottom metal electrode, and a gas-containing gap (4) forming a non-solid dielectric layer between said top (2) and bottom (3) metal electrodes, wherein the distance (D) between the top (2) and bottom (3) metal electrodes is not more than $1\mu$m and the thickness (E) of the top metal electrode (2) is not less than $1\mu$m.

2. The MEMS fixed capacitor of claim 1, wherein the thickness (E) of the top metal electrode (2) is not less than $1.5\mu$m.

3. The MEMS fixed capacitor of claim 1, wherein the thickness (E) of the top metal electrode (2) is not less than $2\mu$m.

4. The MEMS fixed capacitor of any one of claims 1 to 3, wherein the distance (D) between the top (2) and bottom (3) metal electrodes is not more than $0.4\mu$m.

5. The MEMS fixed capacitor of any one of claims 1 to 4, wherein the distance (D) between the top (2) and bottom (3) metal electrodes is not less than $0.15\mu$m.

6. The MEMS fixed capacitor of any one of claims 1 to 5, **characterized by** a deformability parameter DEF of not more than $10^{-4}$ for a voltage V at least up to 45V, and more preferably at least up to 100V, the deformability parameter DEF being defined by the following equation:

$$DEF = \Delta C/(V^2.C_0),$$

wherein:

- V is the value of a voltage applied between the top and bottom metal electrodes;
- $C_0$ is the capacitance value of the MEMS fixed capacitor with no voltage applied between the top (2) and bottom (3) metal electrodes;
- $\Delta C$ is the variation of the capacitance value when a voltage V is applied between the top (2) and bottom (3) metal electrodes.

7. The MEMS fixed capacitor of any one of claims 1 to 6, wherein the top (2) and bottom (3) metal electrodes are made of the same metal.

8. The MEMS fixed capacitor of any one of claims 1 to 6, wherein the top (2) and bottom (3) metal electrodes are made of different metals.

9. The MEMS fixed capacitor of any one of claims 1 to 8, wherein the top electrode (2) is in gold.

10. The MEMS fixed capacitor of any one of claims 1 to 9, wherein said gas-containing gap (4) is a gap containing a dielectric gas.

11. The MEMS fixed capacitor of any one of claims 1 to 9, wherein said gas-containing gap (4) is a gap containing air.

12. The MEMS fixed capacitor of any one of claims 1 to 9, wherein said gas-containing gap (4) is a gap containing a gas under partial vacuum.

13. An Integrated Circuit (IC) comprising at least one electric interconnection line (IL1) embedding at least one MEMS fixed capacitor of any one of the previous claims.

14. A process of manufacturing a MEMS fixed capacitor, and in particular a MEMS fixed capacitor (1 ; 1') of any one of claims 1 to 12, said process comprising the following steps:

(a) depositing a bottom metal layer (L1) onto a substrate (S);
(b) patterning the bottom metal layer (L1) in such a way to create at least one bottom metal electrode (3) in the bottom layer (L1);
(c) depositing a sacrificial layer (SL) onto the bottom layer (L1) and the substrate (S);
(d) patterning the sacrificial layer (SL) in such a way to create wells (W) through the whole thickness of the sacrificial layer (SL);

(e) filling the wells (W) in the sacrificial layer (SL) with a metal in order to form supporting pillars (5 ; 5');
(f) depositing at least one top metal layer (L3/ L3a, L3b) onto the sacrificial layer (SL);
(g) patterning the top metal layer(s) (L3/ L3a, L3b) in order to form at least one top metal electrode (2);
(h) etching the sacrificial layer (SL) in order to remove the whole sacrificial layer (SL) and create the air gap (4) between the top metal electrode (2) and the bottom metal electrode (3).

15. The process of claim 14, wherein steps (e) and (f) are performed separately and successively.

16. The process of claim 14, wherein steps (e) and (f) are performed simultaneously by depositing the at least one top metal layer (L3/ L3a, L3b) onto the sacrificial layer (SL), in such a way to also fill the wells (W) previously formed in the sacrificial layer (SL).

17. The process of any one of claims 14 to 16, wherein the thickness (E) of the top electrode (2) is not less than 1.5$\mu$m, and preferably is not less than 2$\mu$m.

18. The process of any one of claims 14 to 17, wherein the distance (D) between the top (2) and bottom (3) electrodes is not more than 0.4$\mu$m.

19. The process of any one of claims 14 to 18, wherein the distance (D) between the top (2) and bottom (3) electrodes is not less than 0.15$\mu$m.

FIG.1

II – II

E  D  2  4  ◄— L3
◄— L2
5  7  3  7  5  ◄— L1
S

# FIG.2

8b  9  8a  4

III – III  2  E  D  ◄— L3
◄— L2
3  5  ◄— L1
S

# FIG.3

L1

S

FIG.4

7    3    7

FIG.5

3    SL    D

S

FIG.6

FIG.7

FIG. 8

FIG.9

FIG.10

FIG.11

FIG.12

FIG.13

FIG.14

FIG.15

FIG.16

FIG.17

FIG.18

FIG.19

FIG.20

FIG.21

FIG. 22

FIG. 23

Cap 2    Cap 3    IL1

Cap1    XXV  XXV    G

G    G    G    G    G    G    Cap4

Sw1

G    IL2    IC

Sw2    Sw3    Sw4

## FIG.24

Cap1

XXV – XXV
G    5    2    4    E    D    5    G

3    S

## FIG.25

IL1

Cap$_1$  Cap$_2$  Cap$_3$  Cap$_4$

SW$_1$  SW$_2$  SW$_3$  SW$_4$

IL2

FIG.26

Europäisches
Patentamt
European
Patent Office
Office européen
des brevets

**EUROPEAN SEARCH REPORT**

Application Number

EP 12 30 6326

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/057988 A2 (MIMOS BERHAD [MY]; SULAIMAN SURAYA [MY]; SYONO MOHD ISMAHADI [MY]) 7 May 2009 (2009-05-07) * page 4, line 17 - page 17, line 21; claim 1; figures 1,3 * | 1-19 | INV. H01G5/16 H01G5/18 |
| X | US 2011/128083 A1 (POMARICO ANNA [IT] ET AL) 2 June 2011 (2011-06-02) * paragraph [0006] - paragraph [0011] * * paragraph [0024] - paragraph [0040] * * paragraph [0053]; figures 1a,1b,8a,8b,9a,9b * * abstract * | 1-19 | |
| A | US 2005/248423 A1 (QIAN JIANGYUAN [US] ET AL) 10 November 2005 (2005-11-10) * the whole document * | 1-19 | |

TECHNICAL FIELDS
SEARCHED       (IPC)

H01G

The present search report has been drawn up for all claims

| Place of search | Date of completion of the search | Examiner |
|---|---|---|
| Munich | 26 March 2013 | Korb, Wolfgang |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 2 725 595 A1**

### ANNEX TO THE EUROPEAN SEARCH REPORT
### ON EUROPEAN PATENT APPLICATION NO.

EP 12 30 6326

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2013

| Patent document cited in search report | | Publication date | Patent family member(s) | | Publication date |
|---|---|---|---|---|---|
| WO 2009057988 | A2 | 07-05-2009 | NONE | | |
| US 2011128083 | A1 | 02-06-2011 | NONE | | |
| US 2005248423 | A1 | 10-11-2005 | US 2005248423 A1 | | 10-11-2005 |
| | | | US 2008127482 A1 | | 05-06-2008 |
| | | | US 2008129426 A1 | | 05-06-2008 |

EPO FORM P0459

For more details about this annex : see Official Journal of the European Patent Office, No. 12/82

22

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006063257 A
- US 6437965 B